# EUROPEAN PATENT SPECIFICATION

(11) **EP 2 965 364 B1**
(45) Date of publication and mention of the grant of the patent: **08.11.2023**
(21) Application number: 14760882.2
(22) Date of filing: 04.03.2014
(51) Int. Cl.: H01L 31/18

(54) **METHOD FOR ASSEMBLING A PHOTOVOLTAIC MODULE**
VERFAHREN ZUM ZUSAMMENBAU VON EINEM FOTOVOLTAIKMODUL
MÉTHODE D'ASSEMBLAGE D'UN MODULE PHOTOVOLTAÏQUE

(30) Priority: 05.03.2013 FI 20135213
(43) Date of publication of application: 13.01.2016
(73) Proprietor: Valoe Oyj, 50100 Mikkeli (FI)
(72) Inventor: PANTSAR, Henrikki, 00210 Helsinki (FI); LAMPINEN, Ville, 20540 Turku (FI); SAVIKKO, Timo, 02630 Espoo (FI); NIEMINEN, Jarko, 08200 Lohja (FI); SAVISALO, Tuukka, 50100 Mikkeli (FI)
(74) Representative: Papula Oy
(86) International application number: PCT/FI2014/050161
(87) International publication number: WO 2014/135750

(56) References cited:
- US-A1- 2005 172 996
- US-A1- 2009 000 662
- US-A1- 2010 051 085
- US-A1- 2011 132 426
- US-A1- 2012 103 388
- US-A1- 2012 285 501
- US-A1- 2012 312 358
- US-A1- 2013 000 715

## Description

### FIELD OF THE INVENTION

The invention relates to a method for assembling a photovoltaic module.

### BACKGROUND OF THE INVENTION

Photovoltaic cells or solar cells are assembled together to form a photovoltaic module. Such modules are also known as solar modules or solar panels. The photovoltaic module is a large area optoelectronic device that converts the energy of light such as solar radiation directly into electricity by the photovoltaic effect.

Photovoltaic modules are commonly manufactured using crystalline silicon cells that are electrically connected in series using tabs and strings. These assemblies are encapsulated to protect the assembly from environment and also to provide safe electrical connections. The top side of the assembly is generally covered with glass and the backside with flexible polymer laminate, though glass can also be used for the back. This assembly method is difficult to fully automate and thus often involves large amounts of manual labour.

US5972732A describes a "monolithic module assembly", a planar process that is better suited for automation. The process utilizes back contact photovoltaic cells wherein both emitter and collector contacts are on the same side of the photovoltaic cell.

US2013000715A1 describes a method for fabricating back-contact solar cells with a mechanically supporting prepeg backplane. The solar cell with attached template is first placed on top of the backplane.

US2012103388A1 describes a backsheet that can be used in a solar cell module assembly. A patterned adhesive layer comprising a plurality of adhesive regions is deposited on a mounting surface.

US20120312358A1 describes a solar cell module with a circuit film which electrically connects together a first solar cell element and a second solar cell element. An assembly method of said solar cell module is also disclosed wherein a non-light receiving side sealing member sheet is placed above solar cell elements in such a fashion as to cause output-extracting electrodes of solar cell elements and through-holes of first non-light-receiving-side sealing member sheet to be mutually opposed. Paste-like joint member (electrically conductive adhesive)is then injected into the interiors of the through-holes on output-extracting electrodes which oppose through-holes.

A common method to apply interconnecting paste between the photovoltaic cell and the conductive back sheet is to print it to the conductive elements of the back sheet. The problem of this method is that the large area printer used for printing to the connecting pads of the back sheet cannot be positioned accurately over the whole back sheet, since the back sheet may comprise large manufacturing tolerances. The back sheet may be a large object, with surface dimensions of up to 1m x 2m. Ensuring uniform paste and pressure distribution for the whole area is difficult, leading to uneven size and shape of the interconnecting paste across the whole printing area. Also the tooling, such as stencils or screens used to apply the interconnecting paste, are large and expensive. For the large stencil the thermal expansion may lead to significant misalignment of the circuits, contacts on the photovoltaic cells and the interconnecting paste. The shape of the interconnecting paste may result to a shape, where the top is much smaller and less defined than the bottom. As the paste is printed on the back sheet, the shape is not optimal for providing the connection. The contact resistance of the contact pad is significantly larger than on the conductive circuit element, thus the contact pad size on the cell is more critical. The contact resistance on the photovoltaic cell is more difficult to optimize than the contact resistance on the back sheet, therefore narrow paste on the photovoltaic cell may lead to increased contact resistance. After the lamination and the paste curing process poorly defined paste may lead to poor contact not offering enough contact surfaces. Excessive misalignment, caused by inaccuracies of the process or the placement or shape of the conductive circuit elements, may lead to short circuiting of the complete assembly.

### SUMMARY

The present invention discloses a method of assembling a monolithic, back contact photovoltaic module. The photovoltaic module comprises at least one photovoltaic cell comprising electrical contacts on the same side of the cell, a back sheet and a sheet of encapsulant material configured to be assembled between the photovoltaic cell, the back sheet and conductive circuit elements between the back sheet and the sheet of encapsulant material. The method comprises printing at least one layer of interconnecting paste to the electrical contacts of the photovoltaic cell. The details of the method of the invention are defined in accordance to claim 1.

In one embodiment the method comprises assembling the photovoltaic module onto a transparent front sheet, such a glass panel, wherein the photovoltaic module is fully assembled with the front sheet facing down. In one embodiment the method comprises printing the at least one layer of interconnecting paste so as to cause the paste to form bumps with a tapered shape so that the diameter of the bumps is largest at the level of the cell contacts. In one embodiment the method comprises inspecting the cell before printing, causing a defective cell to be rejected.

While not claimed as such, the disclosure also involves a system for assembling a photovoltaic module comprising at least one photovoltaic cell comprising electrical contacts on the same side of the cell, a back sheet, a sheet of encapsulant material configured to be assembled between the photovoltaic cell and the back sheet and conductive circuit elements between the back sheet and the sheet of encapsulant material. The system comprises a printer, a dispenser or other means configured to print at least one layer of interconnecting paste to the electrical contacts of the photovoltaic cell.

The system may comprise means for assembling the photovoltaic module onto a transparent front sheet, wherein the photovoltaic module is fully assembled with the front sheet facing down. In one embodiment the system comprises the printer being configured to print the at least one layer of interconnecting paste so as to cause the paste to form bumps with a tapered shape so that the diameter of the bumps is largest at the level of the cell contacts. In one embodiment the system comprises the printer being configured to inspect the cell, causing a defective cell to be rejected.

The present invention is an assembly process for a monolithic photovoltaic module in which the interconnecting paste is printed on the photovoltaic cell instead of the conductive circuit element. The paste can be printed on the cell in a way that the paste position and shape is very precisely controlled.

The present invention enables using smaller tolerances in the paste to the cell which enable the reduction of the size of the contact pads, reducing the area of the isolated pad, thus increasing the effective area of the cell. Further, the improved tolerances in the assembly process enable more accurate features in the electrical connections of the module. This leads to better area utilization and less electrical resistance in the module and to improved module efficiency. The improved accuracy of printing the interconnecting paste leads to better efficiency and enables the use of more contact points. This opens up possibilities for more efficient electrical circuit design.

Printing the paste on the cell contacts enables also the use of substantially smaller printer equipment than in the traditional approach where the paste is printed on the conductive circuit elements of the large-area back sheet. Further, printing on the cell enables printing a tapered shape interconnecting paste. As a result, the contact on the photovoltaic cell, where the contact resistance is higher, is wider and very well defined.

Printing on the cells provides higher accuracies and thus leads to higher yield and reduces the risk of short circuiting. The contact resistance of the contact pad is significantly larger than on the conductive circuit element. Therefore maximizing the contact area between the paste and the contact pad of the cell provides means for improving the module performance by reducing resistance between the contact pad and the paste. This can be realized by printing the paste on the cell. When printing on the conductive circuit elements instead of cells, the tapered shape of the paste leads to less contact area between the contact pad of the cell and the interconnection paste than the conductive circuit elements and the paste. Printing on the cells and the resulting accuracy improvement further enables more accurate features in the electrical connections of the module, resulting to smaller losses in the module and improved module efficiency.

The photovoltaic cell is manufactured often in a different geographical location than the assembly of the photovoltaic module. The interconnecting paste could oxidize during the transportation; therefore the paste should be applied during the assembly phase. The invention improves the assembly process and enables a step to differentiate the manufacturing process from the assembly process.

### BRIEF DESCRIPTION OF THE DRAWINGS

The accompanying drawings, which are included to provide a further understanding of the invention and constitute a part of this specification, illustrate embodiments of the invention and together with the description help to explain the principles of the invention. In the drawings:
**Fig. 1** is a block diagram illustrating an exemplary embodiment,
**Fig. 2** illustrates device elements, and
**Fig. 3** illustrates one stage of an assembly method according to the invention.

### DETAILED DESCRIPTION OF THE INVENTION

Reference will now be made in detail to the exemplary embodiments of the present invention, examples of which are illustrated in the accompanying drawings.

The photovoltaic module is an assembly comprising several photovoltaic cells that are connected together to increase the amount of power when exposed to light. The assembly usually comprises laminating the components to form a flat and rigid structure. An example of the photovoltaic module is a large flat sandwich structure, comprising a back sheet, conductive circuit elements to which the cells are connected, an encapsulant layer in the form of a sheet of encapsulant material to produce adhesion, mechanical protection and electrical insulation between the layers, photovoltaic cells electrically connected and arranged to be an array, another layer of insulation, typically in the form of another sheet of encapsulant, and the transparent front sheet such as a glass plate. In one example the size of one photovoltaic cell is 156 x 156 mm, wherein the total number of such cells may be 30, 48, 60 or 72 in a single module.

According to the innovation a screen/stencil printer according to prior art may be used for printing on the photovoltaic cells. The printing may also mean inserting volumes of paste dispensed from a nozzle. The accuracy of commercially available solar cell printers enables printing alignment to the cell with very small tolerances and the screen/stencil technology enables accurate engineering of paste shape, size and position. The cells are inspected in the printer for faults, so a defective cell will not reach the assembly cell.

The assembly process may start either from the back sheet or from the transparent front sheet. In the following, the assembly process is explained starting from the back sheet. The back sheet is pre-fabricated, comprising one or more protective layers. Examples of such layers are a layer of polyvinylfluoride and a carrier film commonly made of polyethylene terephthalate, PET. Electrically conductive circuit elements provide the interconnections between photovoltaic cells and a layer of surface protection onto a flat carrier. The electrically conductive circuit elements are arranged between the sheet of encapsulant material and the back sheet. The sheet of encapsulant material is positioned between the conductive circuit elements and the photovoltaic shell, said element providing connection between different photovoltaic cells.

The interconnecting paste is printed to the contact points of the photovoltaic cell. The paste contains metal particles, such as silver, forming after the curing process a solid conductor between the cell contacts, either front or back, and the conductive circuit elements on the back sheet. Instead of a curable paste, the interconnecting material may also be a solder paste. A sheet of encapsulant material is positioned on the back sheet, wherein the holes of the encapsulant sheet are positioned to align to the positions of the interconnecting paste. The encapsulant sheet is for example made of ethyl vinyl acetate (EVA). Back contact photovoltaic cells with the interconnecting paste on the contacts thereof are positioned onto the assembly aligning to the holes in the sheet of encapsulant material and the conductive elements.

Another sheet of encapsulant material is placed on top of the layer of photovoltaic cells and the protective top layer on the sheet of encapsulant material. The protective top layer is for example made of glass. The assembly according to this process may need to be turned around to be laminated with the protective top layer facing down. Before turning the assembly, it may require a preheating step to secure the assembled components.

Reference points are used to determine the assembly locations of the cells relative to the back sheet and in one embodiment the location of the interconnection paste bump to be printed on the cell. The reference points are detected for example by optical recognition means such as a camera and corresponding software in the assembly cell. Reference points may be the contact pads or the isolation area surrounding the contact pad. Fiducials are circuit pattern recognition marks that allow automated assembly equipment to accurately locate and place components on the back sheet. Fiducials may also be used to position the printing of the interconnection paste.

In addition, the method for printing the interconnection paste on the cells enables modification of the paste geometry prior to assembly. One particularly useful paste shape is tapered. The tapered shape results from the printing process and is advantageous, as it creates a larger contact area between the cell and the paste, which has a higher contact resistance. In the case of printing the interconnection paste on the conductive elements of the back sheet, the contact area is larger between the back sheet and the paste, and smaller between the paste and the cell. This results in increased contact resistance and reduces the performance of the module.

If a positional difference exists between the photovoltaic cell and the corresponding contact pad on the back sheet, it may be compensated to some degree by a larger hole and contact pad. On the other hand, the size of the contact pad may be reduced by more accurate positioning of the interconnecting paste.

The assembly is started from the protective top layer such as glass. The glass is placed in the desired position by detecting the locations of edges or corners. An encapsulant layer is placed on top of the glass. Photovoltaic cells with interconnection paste are then placed on the glass and encapsulant. The encapsulant, comprising holes for interconnections, conductive circuit elements and the back sheet are precisely placed on top of the cells, so that the paste creates the interconnection between the cells and the conductive circuit elements through the holes. When the assembled module is already the protective top cover facing down, there is no need to flip the semi-assembled module before entering the final lamination step.

Heat may be applied to fix all components in place. The completed assembly is then moved to the laminating machine, where air is removed from the assembly and heat is applied, allowing the encapsulant material to flow and fill all gaps in the assembly. The heat applied in the laminating process cures the interconnection material. Alternatively a separate process may be used to ensure good electrical contact between the contacts on the photovoltaic cells and the conductors on the back sheet. In one embodiment such process may be soldering.

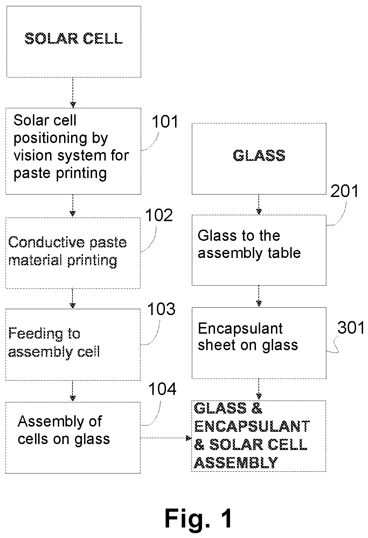

The flow chart of Figure 1 illustrates an assembly method where the assembly is carried out by stacking the layers of the photovoltaic module on a glass cover sheet. For preparing a solar cell for the actual assembly, it is first positioned appropriately for paste printing by a vision system in step 101. Next, in step 102, conductive paste is printed on the contacts on the back side of the cell. The cell with the paste is then fed to the actual assembly cell in step 103 and photovoltaic cells are assembled on the glass in step 104. A sheet of encapsulant material is brought in step 301 onto the glass cover sheet, which is placed on an assembly table in step 201. In step 301, the prepared cells with the paste thereon are assembled in an array on the sheet of encapsulant material lying on the glass cover sheet so as to form a sub-assembly comprising the glass cover sheet, the sheet of encapsulant material, and the array of solar cells. Next, the other sheet of encapsulant material, the conductive circuit elements and the back sheet are added to this sub-assembly (not illustrated in the figure) to form an entire photovoltaic module. Other methods for assembling the module are also possible, for example the assembly does not need to be simultaneous. Different orders of assembling the module are also possible.

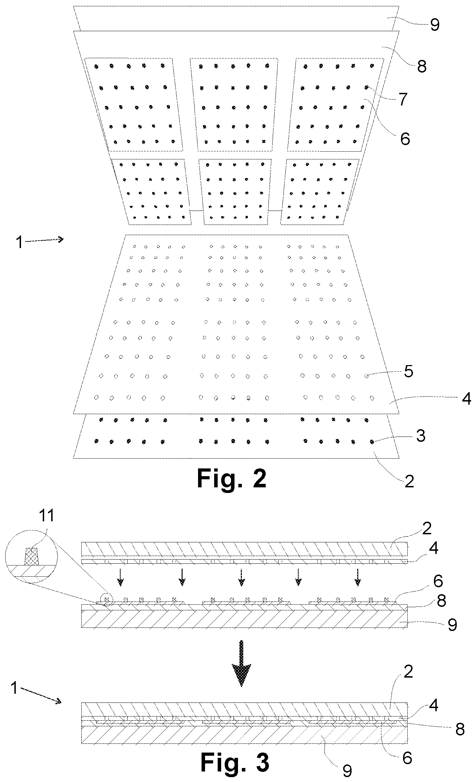

The exploded view of Figure 2 shows the five essential layers of the photovoltaic module 1: a back sheet 2 having contact pads 3 thereon; a first sheet of encapsulant material 4 having interconnecting holes 5 therein; an array of photovoltaic cells 6, each having an array of contacts 7 on the back side of the cell; a second sheet of encapsulant material 8; and a transparent front sheet 9 made of e.g. glass. The exploded view illustrates the importance of accurate positioning of the back sheet, the first sheet of encapsulant, and the array of the photovoltaic cells: the contacts of the cells, the holes in the first sheet of encapsulant material, and the contact pads of the back sheet must coincide in order to form the appropriate electrical connections.

Figure 3 illustrates the assembly of the photovoltaic module 1. In the example of Figure 3, the parts of the photovoltaic module are the same as those in Figure 2. The layer stack of the photovoltaic module 1 is assembled upside down on the front sheet 9. As an essential difference to the prior art assembly methods, bumps of conductive paste 11 are printed directly on the cell contacts instead of the corresponding locations on the back sheet contact pads. As shown in the partial magnification, the bumps 11 have a tapered form, wherein the width of the bump is at its maximum at the level of the cell contact, and narrows as a function of distance from this level. The maximum width at the cell contact minimizes the junction resistance between the cell contact and the encapsulant material. On the other hand, the narrower bumb top facilitates the positioning of the cells with respect to the contact pads of the back sheet and the holes in the first sheet of encapsulant material.

When the second sheet of encapsulant material 8 and the array of photovoltaic cells have been stacked on the front sheet, the first sheet of encapsulant 4 is brought onto the stack.

In Figures 2 and 3, for the sake of clarity of the drawings, the exemplary photovoltaic module comprises only 6 photovoltaic cells. However, in practice, the photovoltaic module may comprise any appropriate number of photovoltaic cells. Typically, a photovoltaic module comprises some tens of photovoltaic cells.

Embodiments of the present invention may be implemented in software, hardware, application logic or a combination of software, hardware and application logic. In an example embodiment, the application logic, software or instruction set is maintained on any one of various conventional computer-readable media. In the context of this document, a "computer-readable medium" may be any media or means that can contain, store, communicate, propagate or transport the instructions for use by or in connection with an instruction execution system, apparatus, or device, such as a computer. A computer-readable medium may comprise a computer-readable storage medium that may be any media or means that can contain or store the instructions for use by or in connection with an instruction execution system, apparatus, or device, such as a computer. The exemplary embodiments can store information relating to various processes described herein. This information can be stored in one or more memories, such as a hard disk, optical disk, magneto-optical disk, RAM, and the like. One or more databases can store the information used to implement the exemplary embodiments of the present inventions. The databases can be organized using data structures (e.g., records, tables, arrays, fields, graphs, trees, lists, and the like) included in one or more memories or storage devices listed herein. The processes described with respect to the exemplary embodiments can include appropriate data structures for storing data collected and/or generated by the processes of the devices and subsystems of the exemplary embodiments in one or more databases.

All or a portion of the exemplary embodiments can be conveniently implemented using one or more general purpose processors, microprocessors, digital signal processors, micro-controllers, and the like, programmed according to the teachings of the exemplary embodiments of the present inventions, as will be appreciated by those skilled in the computer and/or software art(s). Appropriate software can be readily prepared by programmers of ordinary skill based on the teachings of the exemplary embodiments, as will be appreciated by those skilled in the software art. In addition, the exemplary embodiments can be implemented by the preparation of application-specific integrated circuits or by interconnecting an appropriate network of conventional component circuits, as will be appreciated by those skilled in the electrical art(s). Thus, the exemplary embodiments are not limited to any specific combination of hardware and/or software.

If desired, the different functions discussed herein may be performed in a different order and/or concurrently with each other.

Furthermore, if desired, one or more of the above-described functions may be optional or may be combined.

It is obvious to a person skilled in the art that with the advancement of technology, the basic idea of the invention may be implemented in various ways. The invention and its embodiments are thus not limited to the examples described above; instead they may vary within the scope of the claims.

## Claims

1. A method of assembling a photovoltaic module (1) comprising:
a transparent protective top layer (9);
an encapsulant layer (8);
at least one photovoltaic cell (6) comprising electrical contacts (7) on the same side of the cell;
a back sheet (2);
a sheet of encapsulant material (4), comprising holes for interconnections (5), configured to be assembled between the photovoltaic cell and the back sheet; and
conductive circuit elements (3) between the back sheet and the sheet of encapsulant material;
the method comprising:
placing the encapsulant layer (8) on top of the protective layer;
char act e r i zed in that the method comprises:
printing at least one layer of interconnecting paste (11) to the electrical contacts of the photovoltaic cell;
placing the photovoltaic cell with interconnecting paste on the encapsulant layer lying on the transparent protective top layer; and, then,
placing the sheet of encapsulant material, conductive circuit elements and the back sheet on top of the photovoltaic cell so that the interconnecting paste creates an interconnection between the photovoltaic cell and the conductive circuit elements through the holes.

2. The method according to claim 1, **characterized by** printing the at least one layer of interconnecting paste so as to cause the paste to form bumps with a tapered shape.

3. The method according to claim 1, **characterized by** inspecting the cell before printing, causing a defective cell to be rejected.

## Patentansprüche

1. Verfahren zum Zusammenbau eines photovoltaischen Moduls (1), das umfasst:
eine transparente obere Schutzschicht (9);
eine Einkapselungsschicht (8);
wenigstens eine photovoltaische Zelle (6), die elektrische Kontakte (7) auf der gleichen Seite der Zelle umfasst;
eine rückseitige Lage (2);
eine Lage von Einkapselungsmaterial (4), umfassend Löcher für Zwischenverbindungen (5), die dazu konfiguriert ist, zwischen der photovoltaischen Zelle und der rückseitigen Lage eingebaut zu sein; und
leitfähige Schaltungselemente (3) zwischen der rückseitigen Lage und er Lage von Einkapselungsmaterial;
wobei das Verfahren umfasst:
Platzieren der Einkapselungsschicht (8) oben auf der Schutzschicht;
**dadurch gekennzeichnet, dass** das Verfahren umfasst:
Drucken wenigstens einer Schicht aus Zwischenverbindungspaste (11) auf die elektrischen Kontakte der photovoltaischen Zelle;
Platzieren der photovoltaischen Zelle mit der Zwischenverbindungspaste auf der Einkapselungsschicht, die auf der transparenten oberen Schutzschicht liegt; und dann
Platzieren der Schicht aus Einkapselungsmaterial, der leitfähigen Schaltungselemente und der rückseitigen Lage oben auf der photovoltaischen Zelle derart, dass die Zwischenverbindungspaste eine Zwischenverbindung zwischen der photovoltaischen Zelle und den leitfähigen Schaltungselementen durch die Löcher hindurch erzeugt.

2. Verfahren nach Anspruch 1, **gekennzeichnet durch** ein Drucken der wenigstens einen Schicht aus Zwischenverbindungspaste derart, dass bewirkt wird, dass die Paste Erhebungen mit einer sich verjüngenden Gestalt bildet.

3. Verfahren nach Anspruch 1, **gekennzeichnet durch** ein Inspizieren der Zelle vor dem Drucken, was dazu führt, dass eine fehlerhafte Zelle verworfen wird.

## Revendications

1. Procédé d'assemblage d'un module photovoltaïque (1) comprenant :
une couche supérieure protectrice transparente (9) ;
une couche d'encapsulation (8) ;
au moins une cellule photovoltaïque (6) comprenant des contacts électriques (7) du même côté de la cellule ;
une feuille arrière (2) ;
une feuille de matériau d'encapsulation (4), comprenant des trous pour des interconnexions (5), configurée pour être assemblée entre la cellule photovoltaïque et la feuille arrière ; et
des éléments de circuit conducteurs (3) entre la feuille arrière et la feuille de matériau d'encapsulation ;
le procédé comprenant :
le placement de la couche d'encapsulation (8) au-dessus de la couche protectrice ;
**caractérisé en ce que** le procédé comprend :
l'impression d'au moins une couche de pâte d'interconnexion (11) sur les contacts électriques de la cellule photovoltaïque ;
le placement de la cellule photovoltaïque avec la pâte d'interconnexion sur la couche d'encapsulation reposant sur la couche supérieure protectrice transparente, puis
le placement de la feuille de matériau d'encapsulation, des éléments de circuit conducteurs et de la feuille arrière sur le dessus de la cellule photovoltaïque de sorte que la pâte d'interconnexion crée une interconnexion entre la cellule photovoltaïque et les éléments de circuit conducteurs à travers les trous.

2. Procédé selon la revendication 1, **caractérisé par** l'impression de l'au moins une couche de pâte d'interconnexion de manière à amener la pâte à former des protubérances de forme effilée.

3. Procédé selon la revendication 1, **caractérisé par** l'inspection de la cellule avant impression, provoquant le rejet d'une cellule défectueuse.
